(19) 

# Europäisches Patentamt
# European Patent Office
# Office européen des brevets

(11) Publication number: **0 066 041**
**B1**

(12) **EUROPEAN PATENT SPECIFICATION**

(45) Date of publication of patent specification: **08.01.86**

(51) Int. Cl.⁴: **H 01 L 29/86,** H 01 L 23/56

(21) Application number: **82101495.8**

(22) Date of filing: **26.02.82**

(54) Semiconductor device including resistive elements.

(30) Priority: **30.03.81 JP 46900/81**

(43) Date of publication of application:
**08.12.82 Bulletin 82/49**

(45) Publication of the grant of the patent:
**08.01.86 Bulletin 86/02**

(84) Designated Contracting States:
**DE FR GB**

(56) References cited:
**GB-A-2 044 998**
**US-A-4 164 668**

**Patent Abstracts of Japan, vol. 4, no. 44, 5 April 1980, page 134E5**

(73) Proprietor: **Kabushiki Kaisha Toshiba**
**72, Horikawa-cho Saiwai-ku**
**Kawasaki-shi Kanagawa-ken 210 (JP)**

(72) Inventor: **Iida, Norio**
**31 Okamoto**
**Kamakura-shi Kanagawa-ken (JP)**

(74) Representative: **Blumbach Weser Bergen**
**Kramer Zwirner Hoffmann Patentanwälte**
**Radeckestrasse 43**
**D-8000 München 60 (DE)**

Courier Press, Leamington Spa, England.

## Description

The present invention relates to a semiconductor device including resistive elements.

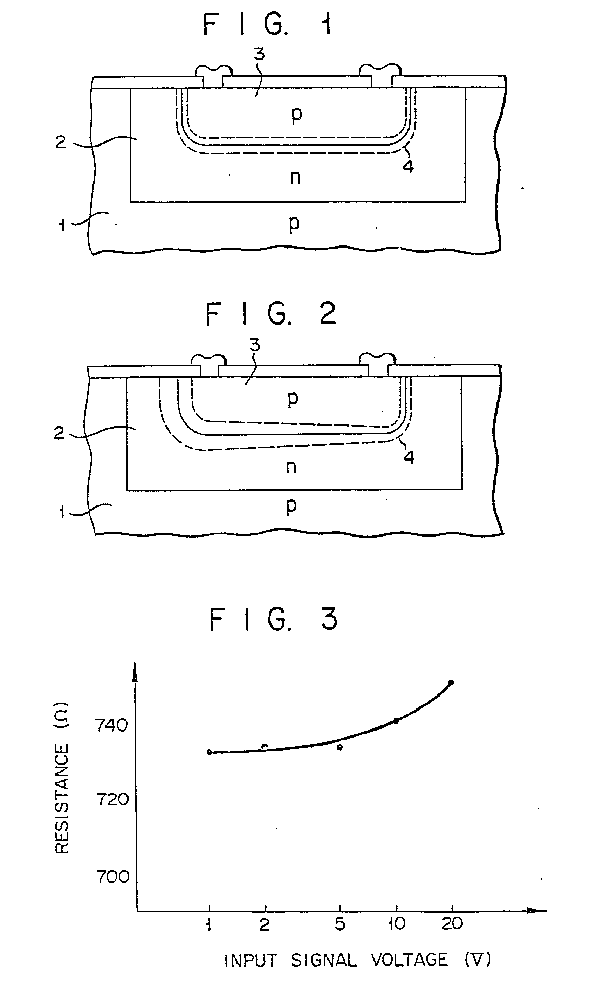

In general, resistive elements used in integrated circuit devices are formed of metal films, polycrystalline silicon layers, diffusion regions, etc. Of those, diffusion resistive elements are predominantly used. Fig. 1 shows a model of an integrated circuit device including a diffusion resistive region. The integrated circuit device is comprised of a p-type semiconductor substrate 1, an isolated region 2 of n-type formed in the substrate, and a p-type diffusion resistive region 3 formed in the surface area of the isolated region 2. In the integrated circuit device, the potential of the isolated region 2 is set at a value higher than the potential of the substrate and the resistive region 3 in order to prevent the formation of parasitic elements such as pnp transistors.

When no current flows through the resistive region 3, the width of a depletion layer 4, as indicated by a broken line in the drawing, which is formed in a p-n junction area between the regions 3 and 2, has a fixed value determined by a potential difference between the regions 3 and 2. On the other hand, when a current flows through the resistive region 3, the width of the depletion layer 4 is gradually made larger in a direction of the current flow, as indicated by a broken line in Fig. 2. As a result, an effective resistance of the diffusion resistive region 3 varies in accordance with a change of a signal voltage applied between both ends of the resistive region 3. In other words, an effective width of the depletion layer 4, i.e. the effective width of the diffusion resistive region 3, changes with the signal voltage applied to the diffusion resistive region 3, with the result that the effective resistance of the region 3 varies.

As described above, in the prior art integrated circuit device, the resistance of the diffusion resistive region varies with the signal voltage applied to the resistive region 3. Therefore, the effective resistance of the resistive region 3 varies, leading to deterioration of the electrical performance of the integrated circuit device.

Accordingly, an object of the present invention is to provide a semiconductor device including a diffusion resistive element whose effective resistance is kept substantially invariable during operation.

This object is achieved with a semiconductor device as claimed in claim 1.

Further improvements of this invention are characterized in the dependent claims.

In the present invention, the current flows into the isolated region in the same direction as that of current flowing into the diffusion resistive region. Accordingly, a substantially fixed reverse bias voltage is applied to the pn junction between the isolated region and the diffusion region. The result is that the width of a depletion layer formed in the junction area between the isolated region and the diffusion resistive region is substantially constant. Therefore, an effective resistance of the diffusion resistive region is kept substantially constant.

This invention can be more fully understood from the following detailed description when taken in conjunction with the accompanying drawings, in which:

Fig. 1 illustrates a model of a prior art integrated circuit device for illustrating the state of a depletion layer formed in the junction area between an isolated region and a diffusion resistive region formed in a surface area of the isolated region when no current flows through the diffusion resistive region;

Fig. 2 shows a model of the prior art device for illustrating the state of a depletion layer formed in the junction area between the isolated region and diffusion resistive region when a current flows into the resistive region;

Fig. 3 shows a graph illustrating the relationship of an input signal voltage applied across the diffusion resistive region and the effective resistance of the diffusion resistive region;

Fig. 4 shows a partial plan view of a semiconductor device which is an embodiment of the present invention;

Fig. 5 shows a cross sectional view taken along line V—V of Fig. 4;

Fig. 6 shows a circuit diagram of a current feed circuit applicable for the semiconductor device shown in Figs. 4 and 5;

Fig. 7 shows a model of a semiconductor device illustrating the state of a depletion layer formed in the junction area between a diffusion resistive region and an isolated region when the current feed circuit shown in Fig. 6 is used; and

Fig. 8 shows a graph illustrating the relationship between an input signal voltage applied to the diffusion resistive region and the effective resistance of the diffusion resistive region when the current feed circuit shown in Fig. 6 is used.

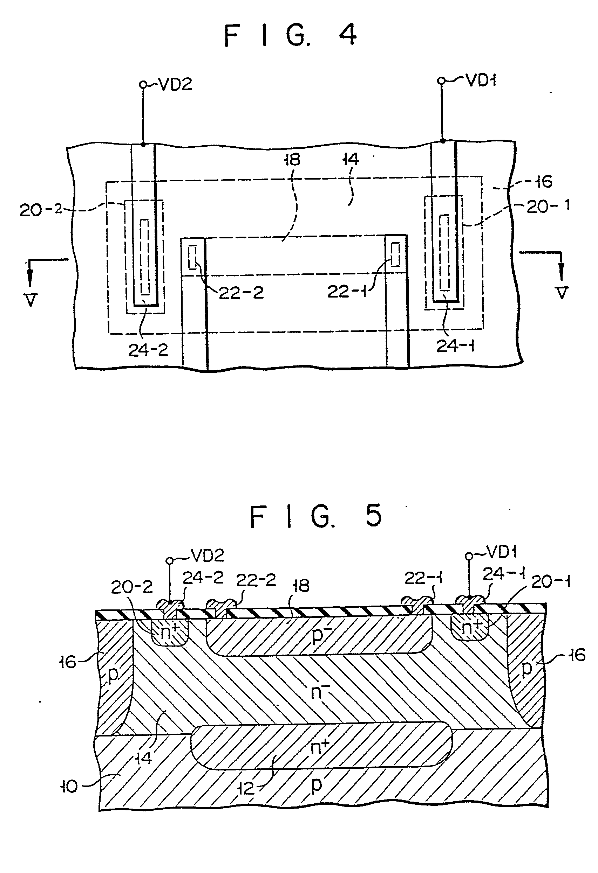

Figs. 4 and 5 show a plan view and a cross sectional view of a semiconductor device embodying the present invention. The semiconductor device is comprised of a p-type substrate 10, an $n^+$-type region 12 formed in the surface area of the substrate 10, $n^-$-type epitaxial layer 14 formed on the substrate 10 and the $n^+$-type region 12, a p-type layer 16 formed on the substrate 10 partially surrounding the $n^-$-type region 14, and a $p^-$-type diffusion region 18 forming a resistor which is formed in the surface area of the $n^-$-type layer 14. As well illustrated in Fig. 4, a pair of $n^+$-type regions 20-1 and 20-2 are formed in the surface area of the $n^-$-type layer 14 and near the respective ends of the diffusion region 18, sandwiching the diffusion region 18. That is, the regions 20-1 and 20-2 are so formed that a current flows in the same direction as that of the current flowing into the diffusion region 18. A pair of electrodes 22-1 and 22-2 are formed in contact with both end portions of the diffusion region 18 and another pair of electrodes 24-1 and 24-2 are formed, respectively, in contact with the $n^+$-type regions 20-1 and 20-2.

The electrodes 24-1 and 24-2 are coupled with power source terminals VD1 and VD2, respectively. A power source voltage is applied between the power source terminals VD1 and VD2 so as to generate in the n⁻-type layer 14 between the electrodes 24-1 and 24-2 a voltage drop corresponding to a signal voltage applied to the resistive region 18, that is, the signal voltage applied between the electrodes 22-1 and 22-2. For example, in a case where the electrode 22-1 is held at a maximum signal potential VG, and a signal voltage from 0 to VG is applied between the electrodes 22-1 and 22-2, the power source voltages VD1 and VD2 (>VG) are applied to the electrodes 24-1 and 24-2. In this case, it is preferable to set a difference voltage (VD1—VD2) between the electrodes 24-1 and 24-2 at a value of approximately VG/2.

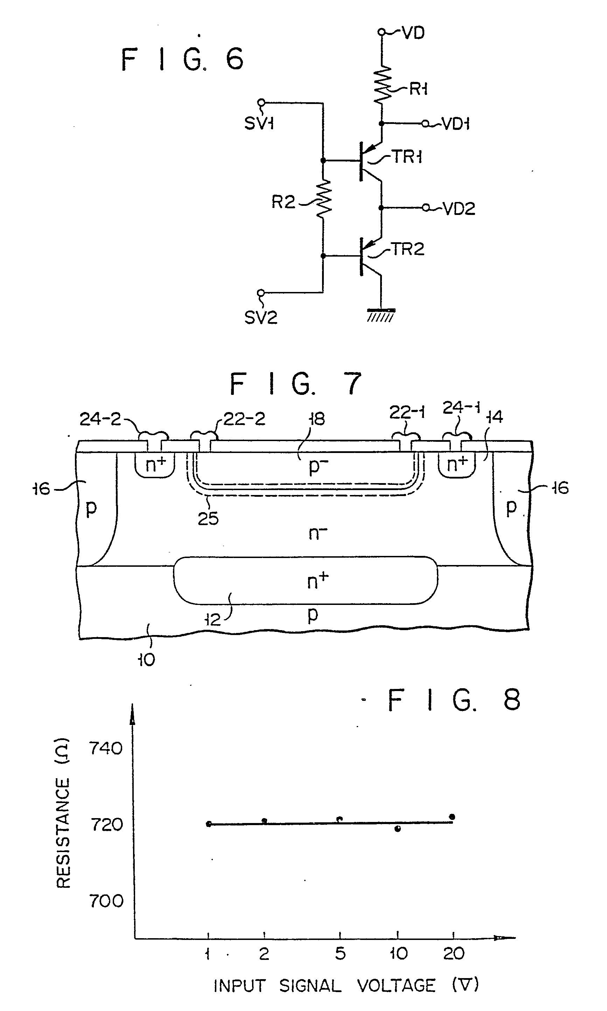

Fig. 6 shows a circuit for generating a voltage drop corresponding to the voltage drop of the resistive region 18 in an n⁻-type region 14 between the electrodes 24-1 and 24-2. The circuit is comprised of a resistor R1 connected at one end to the power source terminal VD, and pnp transistors TR1 and TR2 whose emitter-collector paths are connected in series between the other end of the resistor R1 and ground. A resistor R2 corresponding to the diffusion resistive region 18 is connected between the bases of the transistors TR1 and TR2. Both ends of the resistor R2 are connected to signal input terminals SV1 and SV2 which are also connected, although not shown here, to the electrodes 22-1 and 22-2 of the semiconductor device shown in Fig. 5, the emitters of the transistors TR1 and TR2 are coupled with the electrodes 24-1 and 24-2, respectively.

The resistances between the collectors and emitters of the transistors vary in accordance with the potentials at the signal input terminals SV1 and SV2, respectively. As a result, the emitter voltages of the transistors TR1 and TR2 vary in accordance with a signal voltage. In this case, the voltage between the base and emitter of each of the transistors TR1 and TR2 is held substantially constant. Accordingly, in the semiconductor device shown in Fig. 5, a fixed reverse bias voltage is applied between the isolated region 14 and the diffusion resistive region 18. When using the circuit shown in Fig. 6, the voltage between the electrodes 24-1 and 24-2 changes with a change of the signal voltage between the electrodes 22-1 and 22-2, so that the reverse bias voltage applied to the pn junction between the n⁻-type region 14 and the resistive region 18 is always kept constant at any location of the pn junction. As a result, a depletion layer 25 with a fixed width is formed between the n⁻-type region 14 and the resistive region 18, as shown in Fig. 7. In this case, the width of the depletion layer is always kept at a fixed value. Therefore, it is possible to set an effective resistance of the resistive region 18 at a desired value with a high precision.

The effective resistance of the resistive region 18 is kept substantially constant against a change of the signal voltage applied to the resistive region 18, as shown in Fig. 8. Accordingly, the electrical performance of the integrated circuit device may be improved.

While a specific embodiment of the present invention has been described, it does not limit the present invention as defined in the claims. For example, in the embodiment shown in Fig. 5, the n⁺-type region 12 is formed for preventing the formation of a parasitic element. This region may be omitted, if required. The p-type substrate used in the above-mentioned embodiment may be replaced by the n-type substrate. In this case, the other regions must be of the opposite conductivity type. Further, the n⁻-type layer 14, which is formed on the substrate 10 in the above-mentioned embodiment may be formed in the surface area of the substrate 10 when the n⁺-type region 12 is not formed. In this case, there is no need for forming the p-type isolation region 16.

**Claims**

1. A semiconductor device comprising a semiconductor layer (14) of one conductivity type and a diffusion resistive region (18) of the opposite conductivity type formed in the surface area of said semiconductor layer, means for applying reverse bias voltage to the PN junction between the semiconductor layer (14) and the diffusion resistive region (18), characterized by first and second impurity regions (20-1, 20-2) of the one conductivity type at higher impurity concentration than that of the semiconductor layer (14), said impurity regions (20-1, 20-2) being formed in the surface area of said semiconductor layer (14) with said diffusion resistive region (18) interposed therebetween and current feeding means electrically coupled with said first and second impurity regions (20-1, 20-2) for feeding a current into said semiconductor layer in the same direction as that of current flowing into said diffusion resistive region (18).

2. A semiconductor device according to claim 1, wherein said current feeding means includes first and second electrodes (24-1, 24-2) which are coupled with said first and second impurity regions (20-1, 20-2) and connected to receive first and second power source voltages, respectively.

3. A semiconductor device according to claim 1, wherein said current feeding means is comprised of voltage-dividing means (R1, TR1, TR2) having first and second output terminals (VD1, VD2) electrically coupled with said first and second impurity regions (20-1, 20-2), respectively, first voltage drop means coupled between the first output terminal of said voltage-dividing means and one end of said diffusion resistive region (18) to produce a predetermined voltage drop, second voltage drop means coupled between the second output terminal of said voltage-dividing means and the other end of said diffusion region (18) to produce a predetermined voltage drop.

5

**0 066 041**

6

4. A semiconductor device according to claim 3, wherein said voltage-dividing means has a series circuit of a resistor (R1) and the emitter-collector paths of first and second pnp transistors (TR1, TR2), and the bases of said first and second transistors (TR1, TR2) are connected to said one end and the other end of said diffusion resistive region (18).

5. A semiconductor device according to any one of claims 1 to 4, characterized by a semiconductor substrate (10) of the opposite conductivity type, on which said semiconductor layer (14) is formed.

6. A semiconductor device according to claim 5, further comprising an isolating region (16) of the opposite conductivity type which is formed to extend from the surface of said semiconductor layer (14) to said semiconductor substrate (10) and isolate part of said semiconductor layer from the remaining part.

**Patentansprüche**

1. Halbleitervorrichtung, umfassend eine Halbleiterschicht (14) eines Leitungstyps und eine im Oberflächenbereich dieser Halbleiterschicht ausgebildete Diffusionswiderstandszone (18) des entgegengesetzten Leitungstyps, eine Einrichtung zum Anlegen einer Sperrvorspannung an den PN-Übergang zwischen der Halbleiterschicht (14) und der Diffusionswiderstandszone (18), gekennzeichnet durch eine erste und eine zweite Störstellenzone (20-1, 20-2) des einen Leitungstyps mit einer Störstellenkonzentration, die höher ist als die der Halbleiterschicht (14), wobei die Störstellenzonen (20-1, 20-2) im Oberflächenbereich der Halbleiterschicht (14) ausgebildet sind und die Diffusionswiderstandszone (18) zwischen ihnen liegt, und eine Stromspeiseeinrichtung, die elektrisch mit der ersten und der zweiten Störstellenzone (20-1, 20-2) gekoppelt ist, um einen Strom in die Halbleiterschicht zu speisen in derselben Richtung wie Strom, der in die Diffusionswiderstandszone (18) fließt.

2. Halbleitervorrichtung nach Anspruch 1, bei der die Stromspeiseeinrichtung eine erste und eine zweite Elektrode (24-1, 24-2) aufweist, die mit der ersten bzw. der zweiten Störstellenzone (20-1, 20-2) verbunden sind, um eine erste bzw. eine zweite Stromquellenspannung zum empfangen.

3. Halbleitervorrichtung nach Anspruch 1, bei der die Stromspeiseeinrichtung aufweist: eine Spannungsteilereinrichtung (R1, TR1, TR2) mit einem ersten und einem zweiten Ausgangsanschluß (VD1, VD2), die elektrisch mit der ersten bzw. der zweiten Störstellenzone (20-1, 20-2) verbunden sind, eine erste Spannungsabfalleinrichtung, die zwischen dem ersten Ausgangsanschluß der Spannungsteilereinrichtung und das eine Ende der Diffusionswiderstandszone (18) geschaltet ist, um einen vorbestimmten Spannungsabfall zu erzeugen, eine zweite Spannungsabfalleinrichtung, die zwischen den zweiten Ausgangsanschluß der Spannungsteilereinrichtung und das andere Ende der Diffusionszone (18) geschaltet ist, um einen bestimmten Spannungsabfall zu erzeugen.

4. Halbleitervorrichtung nach Anspruch 3, bei der die Spannungsteilereinrichtung eine Reihenschaltung aus einem Widerstand (R1) und den Emitter-Kollektor-Strechen eines ersten und eines zweiten pnp-Transistors (TR1, TR2) aufweist, wobei die Basen von erstem und zweitem Transistor (TR1, TR2) mit dem einen Ende bzw. dem anderen Ende der Diffusionswiderstandszone (18) verbunden sind.

5. Halbleitervorrichtung nach einem der Ansprüche 1 bis 4, gekennzeichnet durch ein Halbleitersubstrat (10) des entgegengesetzten Leitungstyps, auf dem die Halbleiterschicht (14) ausgebildet ist.

6. Halbleitervorrichtung nach Anspruch 5, ferner umfassend eine isolierende Zone (16) des entgegengesetzten Leitungstyps, die so ausgebildet ist, daß sie sich von der Oberfläche der Halbleiterschicht (14) zum Halbleitersubstrat (10) erstreckt und einen Teil der Halbleiterschicht vom übrigen Teil isoliert.

**Revendications**

1. Dispositif semiconducteur comprenant une couche semiconductrice (14) d'un premier type de conductivité et une région résistive diffusée (18) du type de conductivité opposé formée dans la zone de surface de la couche semiconductrice, des moyens pour appliquer une tension de polarisation inverse à la jonction PN entre la couche semiconductrice (14) et la région résistive diffusée (18), caractérisé par des première et seconde régions d'impuretés (20-1, 20-2) du premier type de conductivité avec des concentrations en impureté plus élevées que celles de la couche semiconductrice (14), des régions d'impuretés (20-1, 20-2) étant formées dans la zone superficielle de la couche semiconductrice (14), la région résistive diffusée (18) étant interposée entre elles, et un moyen d'alimentation en courant couplé électriquement avec les première et second régions d'impuretés (20-1, 20-2) pour fournir un courant dans la couche semiconductrice dans le même sens que celui du courant circulant dans la région résistive diffusée (18).

2. Dispositif semiconducteur selon la revendication 1, dans lequel le moyen d'alimentation en courant comprend des première et seconde électrodes (24-1, 24-2) qui sont couplées aux première et seconde régions d'impuretés (20-1, 20-2) et connectées pour recevoir des première et seconde tensions d'alimentation, respectivement.

3. Dispositif semiconducteur selon la revendication 1, dans lequel le moyen d'alimentation en courant comprend un moyen diviseur de tension (R1, TR1, TR2) ayant des première et seconde régions d'impuretés (20-1, 20-2), respectivement, des premiers moyens de chute de tension couplés entre la première borne de sortie du moyen diviseur de tension et une extrémité de la région résistive diffusée (18) pour produire une chute de tension prédéterminée, et un second moyen de chute de tension couplé entre la seconde borne de sortie du moyen diviseur de tension et l'autre extrémité de la région diffusée (18) pour produire une chute de tension prédéterminée.

4. Dispositif semiconducteur selon la revendication 3, dans lequel le moyen diviseur de tension comprend un circuit série constitué d'une résistance (R1) et des trajets émetteur-collecteur de premier et second transistors pnp (TR1, TR2), et dans lequel les bases des premier et second transistors (TR1, TR2) sont connectées à la première extrémité et à l'autre extrémité de la région résistive diffusée (18).

5. Dispositif semiconducteur selon l'une quelconque des revendications 1 à 4, caractérisé par un substrat semiconducteur (10) du type de conductivité opposé, sur lequel la couche semiconductrice (14) est formée.

6. Dispositif semiconducteur selon la revendication 5, comprenant en outre une région d'isolement (16) du type de conductivité opposé qui est formée pour s'étendre depuis la surface de la couche semiconductrice (14) vers le substrat semiconducteur (10) et isoler une partie de la couche semiconductrice de la partie restante.

F I G. 1

F I G. 2

F I G. 3

# F I G. 4

VD2

VD1

18  14

16

20-2

20-1

22-2  22-1

24-2

24-1

# F I G. 5

VD2  24-2  22-2  18

22-1  VD1  24-1  20-1

20-2

n+

n+

16

p

p-

p

16

n-

14

10

n+

12  p

# F I G. 6

VD
R1
SV1
VD1
TR1
R2
VD2
TR2
SV2

# F I G. 7

24-2  22-2  18  22-1  24-1  14
n⁺  p⁻  n⁺
16  p  16
25  p
n⁻
n⁺
12  p
10

# F I G. 8

RESISTANCE ($\Omega$)

740

720

700

1   2   5   10   20

INPUT SIGNAL VOLTAGE ($\nabla$)

3